# EUROPEAN PATENT APPLICATION

(11) **EP 2 448 020 A1**
(43) Date of publication of application: **02.05.2012**
(21) Application number: 10791785.8
(22) Date of filing: 24.05.2010
(51) Int. Cl.: H01L 33/50

(54) **LIGHT EMITTING MODULE**

(30) Priority: 23.06.2009 JP 2009149112
(71) Applicant: Koito Manufacturing Co., Ltd., Tokyo 108-8711 (JP)
(72) Inventor: DAICHO, Hisayoshi, Shizuoka-shi Shizuoka 424-8764 (JP); MATSUURA, Tatsuya, Shizuoka-shi Shizuoka 424-8764 (JP); KATO, Ken, Shizuoka-shi Shizuoka 424-8764 (JP); SASAKI, Yasutaka, Shizuoka-shi Shizuoka 424-8764 (JP)
(74) Representative: Neobard, William John
(86) International application number: PCT/JP2010/003462
(87) International publication number: WO 2010/150459

(57) **Abstract**

Disclosed is a light emitting module (10) the semiconductor light emitting elements (14) of which emit short wave-length visible light. The plurality of semiconductor light emitting elements (14) are provided in a line on the same flat surface. A light wavelength conversion member (16) converts the wavelength of light that the semiconductor light emitting elements (14) generate, so that white light is emitted. The light wavelength conversion member (16) contains a first phosphor and second phosphor, wherein the wavelength range of wavelength-converted light emitted by each phosphor is different than the excitation wavelength of the other phosphor. The first phosphor is excited by short wavelength visible light and emits yellow light. The second phosphor is excited by short wavelength visible light and emits blue light. The excitation wavelength range of the first phosphor does not include the wavelength range of blue light. The light wavelength conversion member (16) is cured after potting so as to integrally cover the plurality of semiconductor light emitting elements (14).

## Description

### Technical Field

The present invention relates to a light emitting module, and in particular, to a light emitting module comprising a light emitting element and a light wavelength conversion member configured to convert the wavelength of the light emitted by the light emitting element and to emit the light.

### Background Art

Currently, white LEDs (Light Emitting Diodes) emitting white light are widely used. Herein, a white LED emitting white light by additive color mixing of blue light, green light, and red light is proposed, the mixing being achieved by, for example, combining a semiconductor light emitting element emitting the blue light, a phosphor emitting the green light by being excited with the blue light, and a phosphor emitting the red light by being excited with the blue light (see, for example, Patent Document 1). In the white LED, the semiconductor light emitting element emitting the blue light is covered by pouring a binder containing the phosphors into a cup on the bottom of which the semiconductor light emitting element has been arranged.

On the other hand, in a white LED having such a structure, the distance between the semiconductor light emitting element and the emitting surface of a binder paste is not uniform, and hence an amount of light whose wavelength is converted while the light emitted from the semiconductor light emitting element is passing through the binder paste, becomes different in accordance with an emission direction. Accordingly, an area where the binder paste is thick looks yellow because the yellow light emitted after the wavelength thereof has been converted is large in amount, while an area where the binder paste is thin looks blue because yellow light is small in amount. Thus, it becomes difficult to uniformly obtain white light emission. When color shade is generated in a light emitting module, as stated above, it becomes difficult, particularly in applications as light sources for lighting, to provide high quality lighting.

Accordingly, in order to make the thickness of a binder paste containing phosphors to be uniform, a method of forming a light emitting diode has been proposed, in which a fluorescent substance is arranged on an LED chip by an ink jet printing method (see, for example, Patent Document 2). In addition, a light emitting device, which is produced by, for example, depositing a stencil composition in an opening of a stencil whose position has been determined and then by removing the stencil to cure the stencil composition, has been proposed (see, for example, Patent Document 3).

### Patent Documents

[Patent Document 1] Japanese Patent Application Publication No. H10-107325
[Patent Document 2] Japanese Patent Application Publication No. H11-46019
[Patent Document 3] Japanese Patent Application Publication No. 2002-185048

### DISCLOSURE OF THE INVENTION

### Problem to be Solved by the Invention

In the techniques described in the aforementioned Patent Documents 2 and 3, it has been taken into consideration to make the thickness of a binder paste to be uniform, in order to make the color of the light emitted from a light emitting device. However, when it is needed to make the thickness of a binder paste to be uniform, there is the fear that the degree of freedom of the shape of the binder paste may be decreased. On the other hand, LEDs have recently been used in an increasingly wide range of applications, and hence there is a demand for achieving LED light emitting elements having various forms. In this case, when a restriction is set in the shape of a binder paste, there is the possibility that the degree of freedom in designing an LED may be impaired. In particular, when a plurality of semiconductor light emitting elements spaced apart from each other are integrally covered with a binder paste, the distance between each of the semiconductor light emitting elements and the emitting surface of the binder paste does not become uniform only by making the surface of the binder paste to be uniformly flat; and hence it is difficult to obtain a light emitting module emitting uniform color in the techniques described in the aforementioned Patent Documents 2 and 3.

Thus, the present invention has been made to solve the aforementioned problem, and a purpose of the invention is to provide a light emitting module that emits uniform color while the degree of freedom of forms is being secured.

### Means for Solving the Problem

In order to solve the aforementioned problem, a light emitting module according to an embodiment of the present invention comprises: a light emitting element; and a light wavelength conversion member configured to convert the wavelength of the light emitted by the light emitting element and to emit the light. The light wavelength conversion member contains a plurality of phosphors, the wavelength range of the light emitted after the wavelength thereof has been converted by one of the plurality of phosphors being different from the excitation wavelengths for the others, the light wavelength conversion member being formed to cover the light emitting element.

According to the embodiment, it can be avoided that the light whose wavelength has been converted by one of the phosphors may be excited and absorbed by the other phosphors. Accordingly, a light emitting module that emits light having uniform color, independently of the thickness of a light wavelength conversion member, can be obtained.

It may be made that a plurality of the light emitting elements are provided side by side to be spaced apart from each other and the light wavelength conversion member is formed so as to integrally cover the plurality of the light emitting elements.

In recent years, there is a demand for developing light emitting modules that can emit light having uniform color onto a wider area, because it is demanded to use LEDs in the applications as light sources for lighting, etc. However, if a plurality of light emitting elements are arranged so as to be spaced apart from each other in order to achieve a light emitting module that can emit light from a wider area, it becomes difficult to make the distance between each of the plurality of light emitting elements and the emitting surface of a light wavelength conversion member when the light emitting elements are integrally covered with the light wavelength conversion member. According to the embodiment, by using a light wavelength conversion member containing a plurality of phosphors, the wavelength range of the light emitted after the wavelength thereof has been converted by one of the plurality of phosphors being different from the excitation wavelengths for the others, a light emitting module that emits uniform light, even when a plurality of light emitting elements have been provided side by side to be spaced apart from each other, can be achieved.

The plurality of the light emitting elements may be arranged on the same flat surface.

When a plurality of light emitting elements are used, for example, as light sources for lighting, an aspect can be considered in which the plurality of light emitting elements are provided on the same flat surface and side by side so as to be spaced apart from each other. In addition, when a plurality of light emitting elements are provided, it is also strongly demanded to arrange them on the same flat surface, because a substrate can be simply configured when they can be arranging on the same substrate. However, when a plurality of light emitting elements are provided on the same flat surface and side by side so as to be spaced apart from each other, color shade, if any, becomes very noticeable because it becomes possible to visually confirm the light from all of the light emitting elements from the same viewpoint. According to the embodiment, occurrence of color shade can be suppressed even when a plurality of light emitting elements are arranged on the same flat surface. Accordingly, a light emitting module on a flat surface that emits light having uniform color can be achieved. The plurality of the light emitting elements may be provided side by side on a straight line or arranged in a scattered manner on a flat surface.

Another embodiment of the present invention is also a light emitting module. This light emitting module comprises: a light emitting element configured to emit near-ultraviolet light or the light in the wavelength range of short-wavelength visible light; and a light wavelength conversion member that contains both a first phosphor represented by the general formula of M¹O₂•a(M²₁-_{z},M⁴_{z})O•bM³X₂ (wherein, M¹ is at least one element selected from the group consisting of Si, Ge, Ti, Zr, and Sn; M² is at least one element selected from the group consisting of Mg, Ca, Sr, Ba, and Zn; M³ is at least one element selected from the group consisting of Mg, Ca, Sr, Ba, and Zn; X is at least one halogen element; M⁴ is at least one element in which Eu²⁺ is essential selected from the group consisting of rare earth elements and Mn; and a, b, and z are respectively within the ranges of 0.1 ≤ a ≤ 1.3, 0.1 ≤ b ≤ 0.25, and 0.03 < z < 0.8), and a second phosphor that converts the wavelength of the light emitted by the light emitting element and emits blue light, the light wavelength conversion member being formed so as to cover the light emitting element.

As a result of intensive research and development by the present inventors, it has been confirmed that the wavelength range of the light emitted after the wavelength thereof has been converted by either of the aforementioned first phosphor and second phosphor is approximately different from the excitation wavelength for the other. Therefore, according to the embodiment, it can be avoided that the light whose wavelength has been converted by either of the first phosphor and the second phosphor may be excited and absorbed by the other. Accordingly, a light emitting module that emits light having uniform color, independently of the thickness of a light wavelength conversion member, can be obtained.

Also, in this embodiment, it may be made that a plurality of the light emitting elements are provided side by side to be spaced apart from each other and the light wavelength conversion member is formed so as to integrally cover the plurality of the light emitting elements. In addition, the plurality of the light emitting elements may be arranged on the same flat surface. The plurality of the light emitting elements may be arranged on a straight line or in a scattered manner on a flat surface.

### Advantage of the Invention

According to the present invention, a light emitting module that emits uniform color, while the degree of freedom of forms is being secured, can be provided.

### BRIEF DESCRIPTION OF THE DRAWINGS

Fig. 1 is a sectional view illustrating the configuration of a light emitting module according to a first embodiment;
Fig. 2 is a graph illustrating the excitation and emission spectrum of a first phosphor, and the emission spectrum of a second phosphor;
Fig. 3 is a table showing the values for each item with respect to the light emitting module according to the first embodiment and that according to a comparative example;
Fig. 4 is a graph illustrating the emission spectrum of the light emitting module according to the first embodiment;
Fig. 5 is a graph illustrating the emission spectrum of the light emitting module according to the comparative example;
Fig. 6 is a graph illustrating the chromaticity distribution of the light emitted by the light emitting module according to the first embodiment;
Fig. 7 is a graph illustrating the chromaticity distribution of the light emitted by the light emitting module according to the comparative example;
Fig. 8 is a perspective view illustrating the configuration of a light emitting module according to a second embodiment;
Fig. 9 is a table showing the values for each item with respect to the light emitting module according to the second embodiment and that according to the comparative example;
Fig. 10 is a graph illustrating the emission spectrum of the light emitting module according to the second embodiment;
Fig. 11 is a graph illustrating the emission spectrum of the light emitting module according to the comparative example;
Fig. 12 is a view illustrating an area where the luminescent chromaticity of the light emitting module according to the first embodiment is detected;
Fig. 13 is a graph illustrating the chromaticity distribution along the a axis in the light emitting module according to the second embodiment;
Fig. 14 is a graph illustrating the chromaticity distribution along the a axis in the light emitting module according to the comparative example;
Fig. 15 is a graph illustrating the chromaticity distribution along the b axis in the light emitting module according to the second embodiment;
Fig. 16 is a graph illustrating the chromaticity distribution along the b axis in the light emitting module according to the comparative example; and
Fig. 17 is a table showing the difference in the chromaticity at the B point and that at the Y point in each of the light emitting module according to the second embodiment and that according to the comparative example.

### Reference Numerals

- 10: LIGHT EMITTING MODULE

- 12: SUPPORTING SUBSTRATE
- 14: SEMICONDUCTOR LIGHT EMITTING ELEMENT
- 16: LIGHT WAVELENGTH CONVERSION MEMBER
- 30: LIGHT EMITTING MODULE
- 32: CASE
- 34: LIGHT EMITTING ELEMENT UNIT
- 36: LIGHT WAVELENGTH CONVERSION MEMBER
- 38: SUPPORTING SUBSTRATE
- 40: SEMICONDUCTOR LIGHT EMITTING ELEMENT

### BEST MODE FOR CARRYING OUT THE INVENTION

Hereinafter, embodiments of the present invention will be described in detail with reference to the accompanying drawings.

### (First Embodiment)

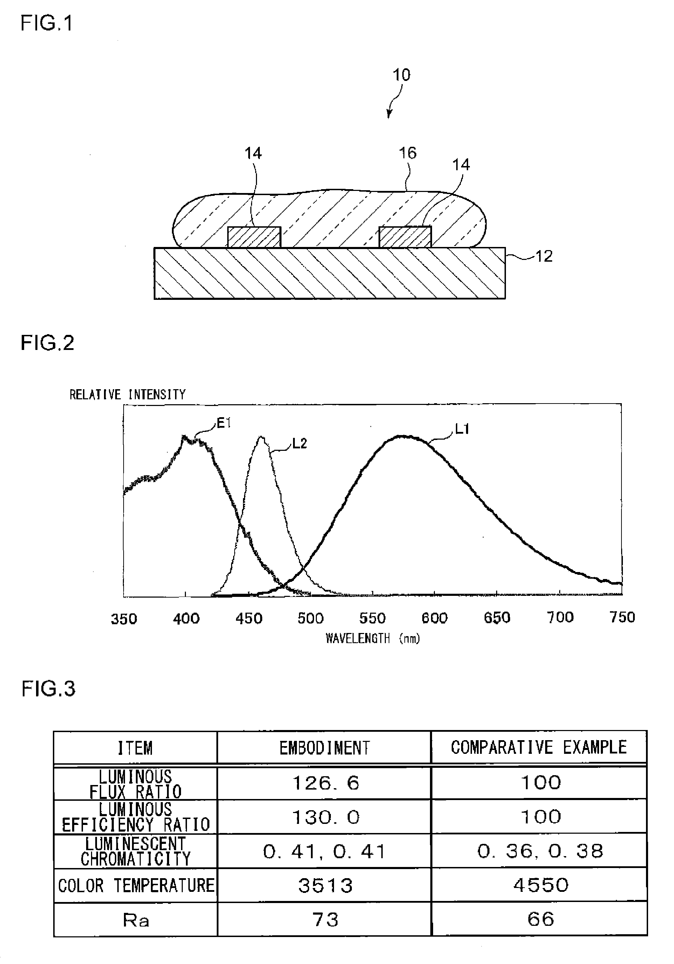

Fig. 1 is a sectional view illustrating the configuration of a light emitting module 10 according to a first embodiment. The light emitting module 10 has a supporting substrate 12, a semiconductor light emitting element 14, and a light wavelength conversion member 16.

### (1) Supporting Substrate

The supporting substrate 12 is formed of aluminum nitride (AlN) and circuits are formed on the upper surface thereof by gold evaporation. The supporting substrate 12 may be formed of another material having no conductivity but high thermal conductivity, such as, for example, alumina, mullite, ceramic, such as glass ceramic, glass epoxy, or the like. In the first embodiment, the supporting substrate 12 is formed into a rectangular plate shape having a length of 6 mm, a width of 1 mm, and a thickness of 1 mm.

### (2) Semiconductor Light Emitting Element

In the first embodiment, an LED emitting near-ultraviolet light or short-wavelength visible light was adopted as the semiconductor light emitting element 14. The semiconductor light emitting element 14 is formed into, for example, a chip having a size of 1 umm × 1 mm, and is provided such that the central wavelength of the emitted light is approximately 400 nm. In the first embodiment, MvpLED (trademark) SL-V-U40AC made by SemiLEDs Corporation, having a leak wavelength at 402 nm, was used for the semiconductor light emitting element 14. It is needless to say that the semiconductor light emitting element 14 is not limited thereto, but, for example, a semiconductor laser diode (LD) may be adopted.

A semiconductor light emitting element of a so-called vertical chip type is adopted as the semiconductor light emitting element 14. It is needless to say that a semiconductor light emitting element of another type may be adopted as the semiconductor light emitting element 14, and, for example, a semiconductor light emitting element of a so-called flip-chip type or a so-called face-up type may be adopted as that.

A plurality of the semiconductor light emitting elements 14 are provided on the same flat surface of the supporting substrate 12 and side by side so as to be spaced apart from each other. Specifically, the two semiconductor light emitting elements 14 are mounted in series on the supporting substrate 12, the elements 14 being 2.3 mm spaced apart from each other. It is needless to say that the number of the semiconductor light emitting elements 14 and an interval between them are not limited to these. In addition, the supporting substrate 12 may be provided on a surface other than the same flat surface, for example, on a curved surface or on respective steps provided on a surface.

### (3) Light Wavelength Conversion Member

The light wavelength conversion member 16 is formed so as to integrally cover a plurality of the semiconductor light emitting elements 14. The light wavelength conversion member 16 contains a first phosphor and a second phosphor, the wavelength range of the light emitted after the wavelength thereof has been converted by either of the two being approximately different from the excitation wavelength for the other. The light wavelength conversion member 16 is formed by containing the first and second phosphors into a transparent binder paste to produce a phosphor paste and by potting the phosphor paste so as to integrally cover the plurality of the semiconductor light emitting elements 14 and then by curing it.

### (4) First Phosphor

A material that efficiently absorbs near-ultraviolet light or short-wavelength visible light but hardly absorbs visible light having a wavelength of 450 nm or more, is used for the first phosphor. The first phosphor is a yellow phosphor that converts the wavelength of near-ultraviolet light or short-wavelength visible light and emits yellow light, in which the dominant wavelength of the emitted light is 564 nm or more and 582 nm or less.

In the first embodiment, a phosphor represented by SiO₂•1.0 (Ca_{0.54}, Sr_{0.36}, Eu_{0.1}) 0•0.17SrCl₂ was used as the first phosphor. The first phosphor is one in which cristobalite has been generated by adding an excessive amount of SiO₂ in the mixing ratio of raw materials.

In producing the first phosphor, each material of SiO₂, Ca(OH)₂, SrCl₂•6H₂O, and Eu₂O₃ was first weighed such that the molar ratio of these materials was SiO₂ : Ca(OH) 2 : SrCl₂•6H₂O : Eu₂O₃ = 1.1 : 0.45 : 1.0 : 0.13. Subsequently, each material thus weighed was put into an alumina mortar to grind and mix it for 30 minutes, thereby obtaining a material mixture. A fired substance was obtained by putting the material mixture into an alumina crucible to fire it in an electric furnace having a reducing atmosphere (H₂/N₂: 5/95) and at 1030°C for 5 to 40 hours. The first phosphor was obtained by carefully washing the obtained fired substance with hot pure water.

A material of which the first phosphor is formed is not limited to the aforementioned material, but other materials represented by the general formula of M¹O₂•a(M²_{1-z},M⁴_{z})O•bM³X₂ may be adopted. Herein, M¹ represents at least one element selected from the group consisting of Si, Ge, Ti, Zr, and Sn. M² represents at least one element selected from the group consisting of Mg, Ca, Sr, Ba, and Zn. M³ represents at least one element selected from the group consisting of Mg, Ca, Sr, Ba, and Zn. X represents at least one halogen element, M⁴ represents at least one element in which Eu²⁺ is essential selected from the group consisting of rare earth elements and Mn, and a, b, and z are respectively within the ranges of 0.1 ≤ a ≤ 1.3, 0.1 ≤ b ≤ 0.25, and 0.03 < z < 0.8. In the first phosphor adopted in the first embodiment, the following equations hold in this general formula: M¹ = si; M² = Ca/Sr (molar ratio: 60/40) ; M³ = Sr; X = Cl; M⁴ = Eu²⁺; a = 0. 9, b = 0.17, and c/ (a+c) = 0.1 (wherein, C is the content of M⁴ (molar ratio)).

### (5) Second Phosphor

The second phosphor is a blue phosphor that converts the wavelength of near-ultraviolet light or short-wavelength visible light and emits blue light. A phosphor that efficiently absorbs near-ultraviolet light or red light and emits the light whose dominant wavelength is 440 nm or more and 470 nm or less is used as the second phosphor. In the first embodiment, the phosphor represented by (Ca₄.₆₇Mg_{0.5}) (PO₄)₃Cl:Eu_{0.08} was used as the second phosphor. The second phosphor is not limited thereto, but may be selected from the group consisting of the phosphors represented by the following general formulae.

### General Formula of M¹a(M²O₄)_{b}X_{c}:Re₄

M¹ includes one or more elements selected from the group of Ca, Sr, and Ba as essential elements, and part of M¹ can be substituted with the element selected from the group consisting of Mg, Zn, Cd, K, Ag, and Tl. M² includes P as an essential element, and part of M² can be substituted with the element selected from the group consisting of V, Si, As, Mn, Co, Cr, Mo, W, and B. X represents at least one halogen element, and Re represents at least one rare earth element in which Eu²⁺ is essential, or Mn. In addition, it is made that a, b, c, and d are respectively within the ranges of 4.2 ≤ a ≤ 5.8, 2.5 ≤ b ≤ 3.5, 0.8 < c < 1.4, and 0.01 < d < 0.1.

### General Formula of M¹₁₋ₐMgAl₁₀O₁₇:Eu²⁺ₐ

It is made that M¹ is at least one element selected from the group consisting of Ca, Sr, Ba, and Zn, and a is within a range of 0.001 ≤ a ≤ 0.5.

### General Formula of M¹₁₋ₐMgSi₂O₈:Eu²⁺ₐ

It is made that M¹ is at least one element selected from the group consisting of Ca, Sr, Ba, and Zn, and a is within a range of 0.001 ≤ a ≤ 0.8.

### General Formula of M¹₂₋ₐ(B₅O₉)X:Reₐ

It is made that M¹ is at least one element selected from the group consisting of Ca, Sr, Ba, and Zn, X is at least one halogen element, and a is within a range of 0.001 ≤ a ≤ 0.5.

In producing the second phosphor, each material of CaCO₃, MgCO₃, CaCl₂, CaHPO₄ and Eu₂O₃ was first weighed such that the molar ratio of these materials was CaCO₃ : MgCO_{3 :} CaCl₂ : CaHPO₄ : Eu₂O₃ = 0.42 : 0.5 : 3.0 : 1.25 : 0.04, and each weighed material was put into an alumina mortar to grind and mix it for 30 minutes, thereby obtaining a material mixture. A fired substance was obtained by putting the material mixture into an alumina crucible to fire it under N₂ atmosphere containing H₂ in an amount of 2 to 5% and at a temperature of 800°C or higher to lower than 1200°C for 3 hours. The second phosphor was obtained by carefully washing the obtained fired substance with hot pure water.

### (6) Binder Material

A material that is transparent with respect to near-ultraviolet light or short-wavelength visible light, i.e., has the transmittance of these light of 90% or higher, and that has a good light resistance property, is used as a binder material. In the first embodiment, a silicone resin was used as the binder material. Specifically, a dimethyl silicone resin (JCR6126 made by Dow Corning Toray Co., Ltd.) having a good light resistance property was used as the binder material. However, the binder material is not limited thereto, but, for example, a fluorine resin, sol-gel glass, acrylic resin, inorganic binder, and glass material, etc., can be used.

In the first embodiment, the binder paste was formed by dispersing silica fine particles into the silicone resin as a thixo agent. Alternatively, other materials may be used as a diffusing agent and a thixo agent, and fine particles, for example, such as silicon dioxide, titanium oxide, aluminum oxide, and barium titanate, may be contained in the binder paste.

### (7) Method of Producing Light Emitting Module

In producing the light emitting module 10, an electrode pattern including an anode and a cathode was first formed on the supporting substrate 12 by gold evaporation in advance. Subsequently, a silver paste (84-1LMISR4 made by Ablestik Co., Ltd.) was dropped on the anode on the supporting substrate 12 by using a dispenser, and the lower surface of each of the two semiconductor light emitting elements 14 was adhered onto the anode. Thereafter, the silver paste was cured under an environment at 175°C for one hour. Subsequently, gold wires each having a diameter of 45 µmφ were bonded, by ultrasonic thermocompression bonding, to each of the electrode on the upper side of the semiconductor light emitting element 14 and the cathode on the supporting substrate 12.

In producing the phosphor paste, the first phosphor and the second phosphor were first mixed at a weight ratio of 2 : 1, and the mixed phosphor was blended into the binder material made of the dimethyl silicone resin in an amount of 1.8% by volume. The phosphor paste was produced by filling an ointment container having a volume of 10 cc with 3 g or more and 5 g or less of the above blended phosphor to mix it at a revolution of 1200 rpm and a rotation of 400 rpm for 90 seconds by using a rotary and revolutionary mixer (MAZERUSTAR made by Kurabo Industries Ltd.).

This phosphor paste was potted by using a syringe having a volume of 2.5 cc (discharge port diameter: 1 mmφ) so as to cover the semiconductor element. The phosphor paste was cured by further subjecting it to a heating treatment at 150°C for one hour, thereby forming the light wavelength conversion member 16. The light wavelength conversion member 16 after being cured has an indeterminate shape having a width of 2 mm or more to 4 mm or less, a height of 2 mm or more to 3 mm or less, and a length of approximately 7 mm.

Fig. 2 is a graph illustrating the excitation and emission spectrum of the first phosphor, and the emission spectrum of the second phosphor. In Fig. 2, L1 indicates the emission spectrum by which the wavelength range of the light emitted after the wavelength thereof has been converted by the first phosphor is illustrated, L2 indicates the emission spectrum by which the wavelength range of the light emitted after the wavelength thereof has been converted by the second phosphor is illustrated, and E1 indicates the excitation spectrum by which the excitation wavelength range of the light whose wavelength is converted by the first phosphor is illustrated. Because it is clear that the excitation spectrum for the second phosphor is not overlapped with the emission spectrum of the first phosphor, the illustration of the excitation spectrum for the second phosphor is omitted.

As illustrated in Fig. 2, the excitation spectrum E1 for the first phosphor is hardly overlapped with the emission spectrum L2 of the second phosphor. Also, as stated above, the excitation spectrum for the second phosphor is not overlapped with the emission spectrum of the first phosphor. Accordingly, the wavelength range of the light emitted after the wavelength thereof has been converted by either of the first phosphor and the second phosphor is approximately different from the excitation wavelength range for the other. Accordingly, the blue light emitted after the wavelength thereof has been converted by the second phosphor can pass through the light wavelength conversion member 16 with hardly being absorbed by the first phosphor. Also, the yellow light emitted after the wavelength thereof has been converted by the first phosphor can pass through the light wavelength conversion member 16 with hardly being absorbed by the second phosphor.

Therefore, according to the light wavelength conversion member 16 of the first embodiment, it becomes possible to emit the light having uniform color from the whole emitting surface of the light wavelength conversion member 16, even if the thickness of the binder paste is not uniform, i.e., the distance between the light emitting surface of the semiconductor light emitting element 14 and the emitting surface of the light wavelength conversion member 16 is not uniform. Accordingly, a light emitting module emitting uniform color can be produced, even when the wavelength conversion member 16 is formed by using a potting method, etc.

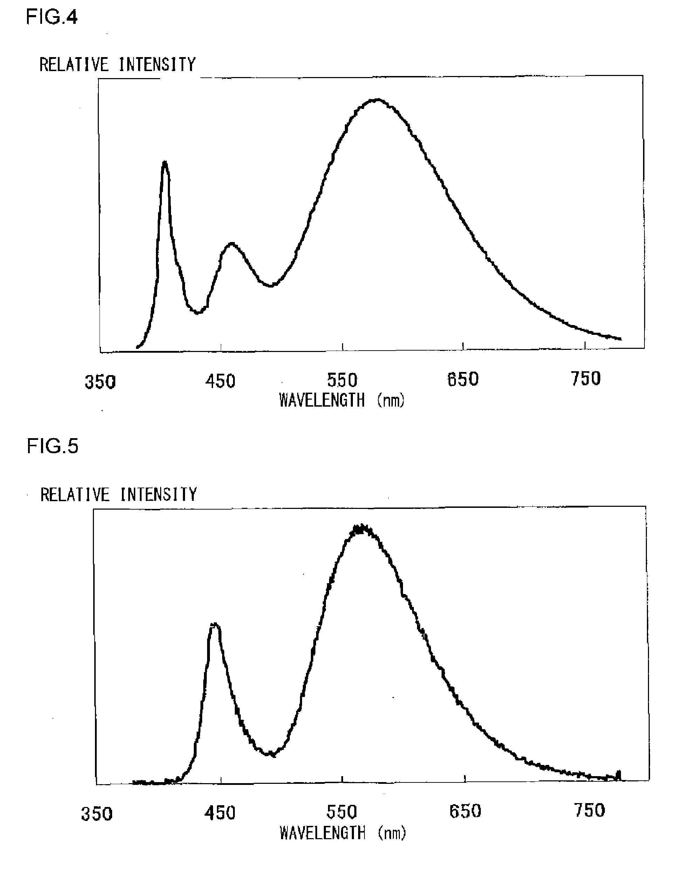

Fig. 3 is a table showing the values for each item with respect to the light emitting module 10 according to the first embodiment and to a light emitting module according to a comparative example. Fig. 4 is a graph illustrating the emission spectrum of the light emitting module 10 according to the first embodiment, and Fig. 5 is a graph illustrating that of the light emitting module according to the comparative example. In order to check the light emitting property of the light emitting module 10, that of the light emitting module according to the comparative example was also checked. In the light emitting module according to the comparative example, a comparative phosphor was used instead of the first phosphor and the second phosphor. In a phosphor paste in the light emitting module according to the comparative example, the comparative phosphor was blended in the dimethyl silicone resin in an amount of 0.7% by volume. Yttrium aluminum garnet activated by cerium (P46-Y3 made by Kasei Optonix Co. , Ltd.) was used as the comparative phosphor. Other than that, the configuration of the light emitting module according to the comparative example was the same as that of the light emitting module 10.

The light emitting properties of the light emitting module 10 and the light emitting module according to the comparative example were checked by driving each of them with a current of 700 mA. In Fig. 3, each of the luminous flux ratio and luminous efficiency ratio represents a ratio when that of the comparative example is indicated by 100. As known from Fig. 3, the light emitting module 10 according to the first embodiment has a luminous flux and luminous efficiency higher than those of the light emitting module according to the comparative example, and further has a good color rendering property.

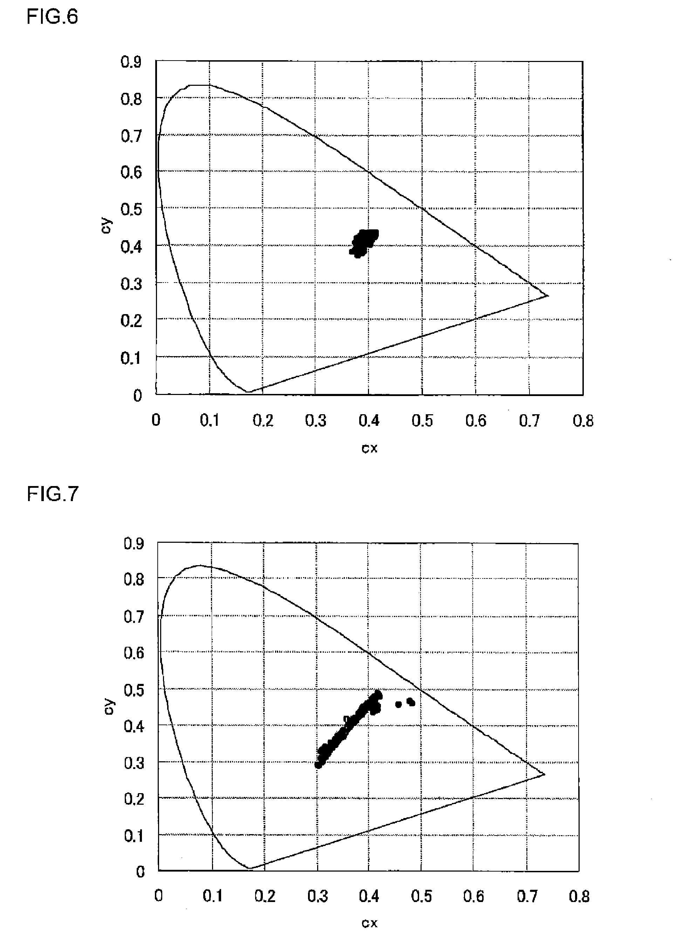

Fig. 6 is a graph illustrating the chromaticity distribution of the light emitted by the light emitting module 10 according to the first embodiment. Fig. 7 is a graph illustrating the chromaticity distribution of the light emitted by the light emitting module according to the comparative example. The chromaticity distributions were obtained by checking, with the use of CA 1500 made by Minolta Company Ltd. as a color luminance meter, the chromaticity on the potting surface of each of the light emitting module 10 and that according to the comparative example, the potting surface being divided into squares each area of which was approximately 50 µm². In order to evaluate a chromaticity error in each of the light emitting modules, the chromaticity distribution on the middle line in the longitudinal direction of each of the light emitting modules was plotted in Figs. 6 and 7.

It is known from Figs. 6 and 7 that light having the same chromaticity is emitted from each area of the light emitting module 10. On the other hand, in the light emitting module according to the comparative example, it is known that bluish white light is emitted near the area directly above the semiconductor light emitting element 14, and that the bluish white light is changed to yellowish white light as it is away from the area directly above the semiconductor light emitting element 14 and a color error also becomes large. For example, when the light emitting module according to the comparative example is used as a light source for lighting, a color error is further enlarged because bluish white portion of light and yellowish while portion thereof are generated in accordance with an area to which the light is emitted, etc. Thereby, the quality of lighting is greatly impaired. According to the light emitting module 10 of the first embodiment, such a color error can be suppressed and it becomes possible to light up, with uniform white light, an area to which light is emitted. Accordingly, it is known that the light emitting module 10 is particularly useful in the applications as a light source for lighting.

As stated above, a light emitting module in which color shade is little can be obtained by performing potting so as to cover the semiconductor light emitting element 14, with the light wavelength conversion member 16 containing a first phosphor and a second phosphor, the wavelength range of the light emitted after the wavelength thereof has been converted by either of the two being approximately different from the excitation wavelength for the other.

### (Second Embodiment)

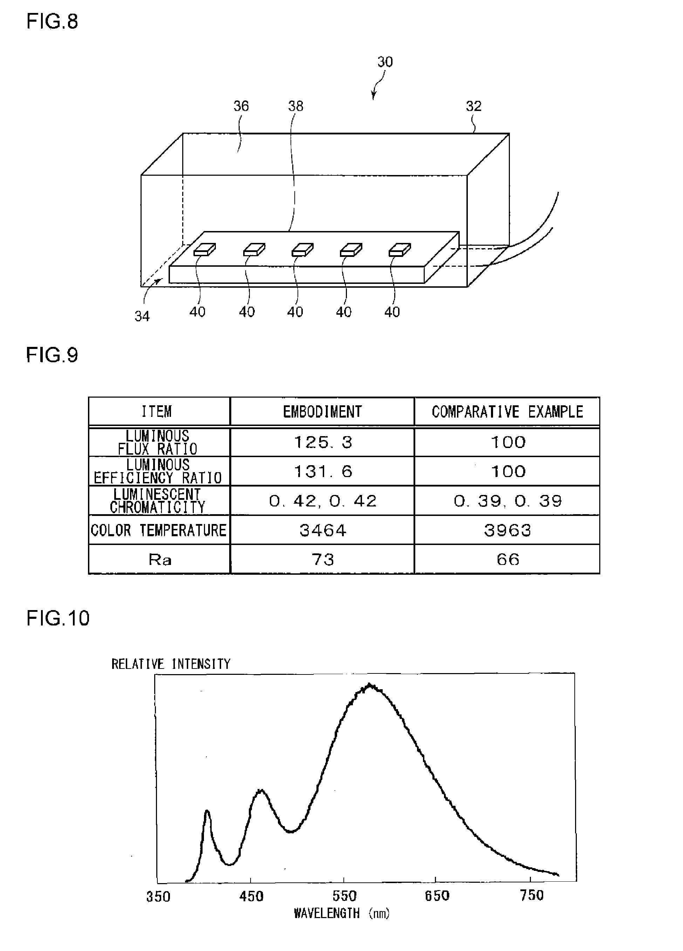

Fig. 8 is a perspective view illustrating the configuration of a light emitting module 30 according to a second embodiment. The light emitting module 30 has a case 32, a light emitting element unit 34, and a light wavelength conversion member 36.

The case 32 is formed, with transparent polycarbonate, into a box-shaped rectangular parallelepiped having a length of 45 mm, a width of 8 mm, a height of 5 mm, and a thickness of 0.2 mm, only the upper surface of which is opened. The light emitting element unit 34 includes a supporting substrate 38 and a semiconductor light emitting element 40. The supporting substrate 38 is the same as the supporting substrate 12 according to the first embodiment in that it is formed of aluminum nitride and circuits are formed on the upper surface thereof by gold evaporation. The supporting substrate 38 is formed into a rectangular plate shape having a length of 40 mm, a width of 5 mm, and a thickness of 1 mm.

The semiconductor light emitting element 40 is the same as the semiconductor light emitting element 14 according to the first embodiment. In the second embodiment, the light emitting element unit 34 is configured with the five semiconductor light emitting elements 40 being provided side by side and in series on the supporting substrate 38. The interval between the semiconductor light emitting elements 40 is made to be 5 mm.

The light emitting element unit 34 was housed in the case 32 and fixed to the bottom surface of the case 32. A power supplying cord for supplying a current to the light emitting element unit 34 was pulled out from the side of the case 32.

In producing a phosphor paste, a first phosphor and a second phosphor were first mixed at a weight ratio of 2:1, and the mixed phosphor was blended into a binder material made of the dimethyl silicone resin in an amount of 3.0% by volume. The mixing method was the same as that in the first embodiment.

The case 32, the bottom of which the light emitting element unit 34 had been fixed to, was filled with this phosphor paste by using a syringe having a volume of 2.5 cc (discharge port diameter: 1 mmφ). Thereafter, the upper surface of the phosphor paste was put into a flat state with a squeegee. The phosphor paste was cured by further subjecting it to a heating treatment at 150° for one hour, thereby forming the light wavelength conversion member 36.

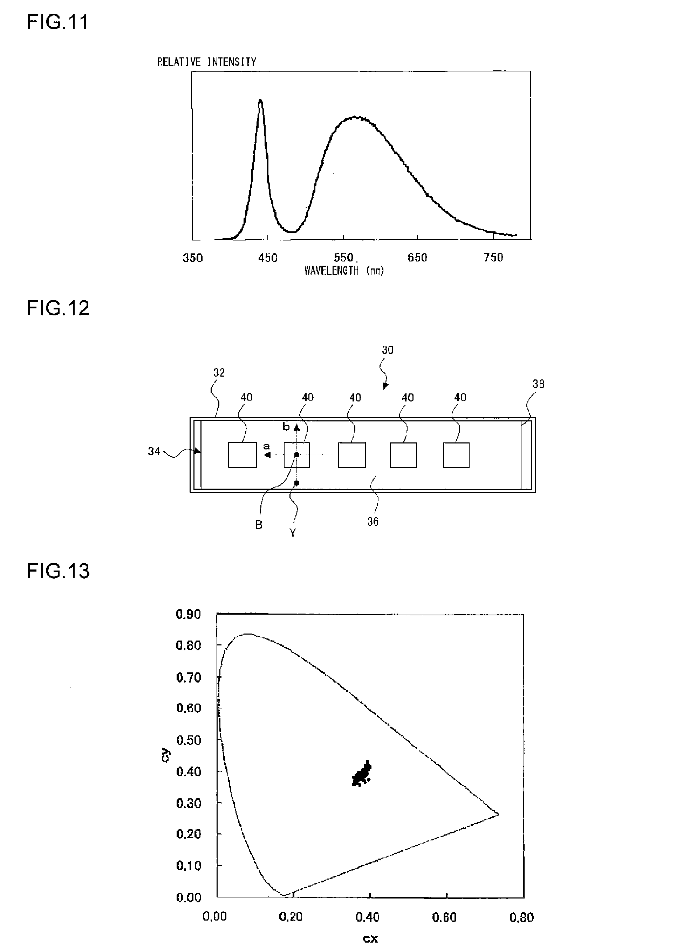

Fig. 9 is a table showing the values for each item with respect to the light emitting module 30 according to the second embodiment, and to the light emitting module according to a comparative example. Fig. 10 is a graph illustrating the emission spectrum of the light emitting module 30 according to the second embodiment, and Fig. 11 is a graph illustrating that of the light emitting module according to the comparative example. Also, in the second embodiment, the light emitting property of the light emitting module according to the comparative example was checked in order to check that of the light emitting module 30. In the light emitting module according to the comparative example, a comparative phosphor was used instead of the first phosphor and the second phosphor. The materials of the comparative phosphor were the same as those in the first embodiment. In a phosphor paste in the light emitting module according to the comparative example, the comparative phosphor was blended in the dimethyl silicone resin in an amount of 0.18% by volume. Other than that, the configuration of the light emitting module according to the comparative example was the same as that of the light emitting module 10.

The light emitting properties of the light emitting module 30 and the light emitting module according to the comparative example were checked by driving each of them with a current of 700 mA. In Fig. 9, each of the luminous flux ratio and luminous efficiency ratio represents a ratio when that of the comparative example is indicated by 100. As known from Fig. 9, the light emitting module 30 according to the second embodiment has a luminous flux and luminous efficiency higher than those of the light emitting module according to the comparative example, and further has a good color rendering property.

Fig. 12 is a view illustrating an area where the luminescent chromaticity of the light emitting module 30 according to the first embodiment is detected. Fig. 12 illustrates the above area by using a top view of the light emitting module 30.

The luminescent chromaticity of the light emitting module 30 was checked in an area corresponding to the semiconductor light emitting element 40 located second from the end. Specifically, assuming that an area on the upper surface of the light wavelength conversion member 36, vertically above the center of the aforementioned light emitting element 40, was the original point, luminescent chromaticity was detected while moving an area where the luminescent chromaticity was to be detected with respect to both on the a axis passing through the original point and parallel to the direction in which the supporting member 38 extended, and on the b axis passing through the original point and perpendicular to the direction in which the supporting substrate 38 extended, thereby the chromaticity distribution was checked with respect to each of the axes. In this case, the chromaticity was detected, with the use of CA 1500 made by Minolta Company Ltd. as a color luminance meter, in an area of 50 µm² on the upper surface of the light wavelength conversion member 36. Further, the chromaticity was detected at each of the B point vertically above the center of the light emitting element 40 and the Y point on the b axis a predetermined distance (approximately 1 mm) away from the B point. The same check as described above was also performed on the light emitting module according to the aforementioned comparative example.

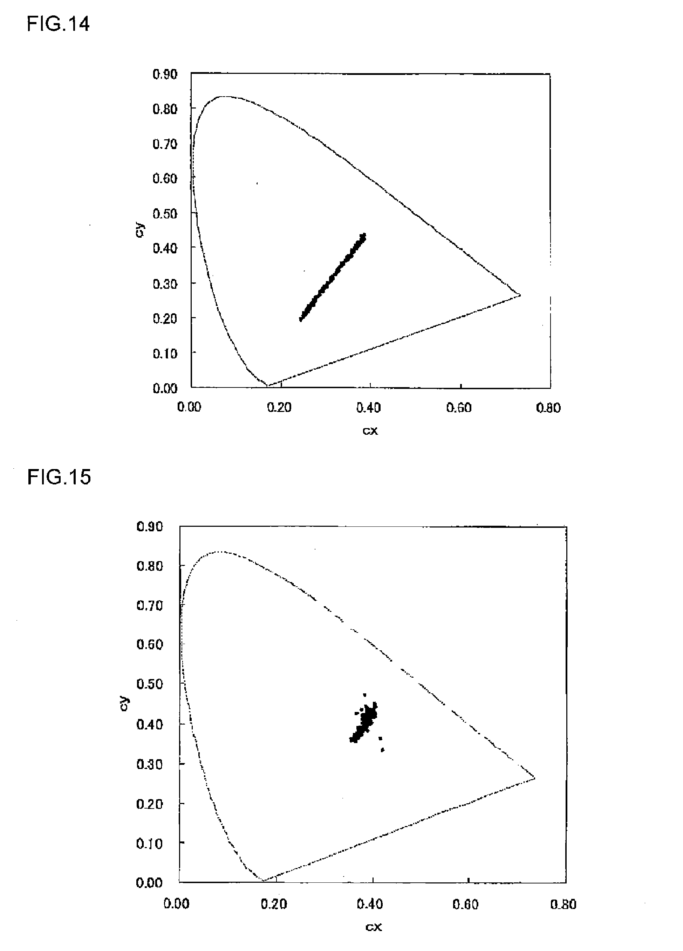

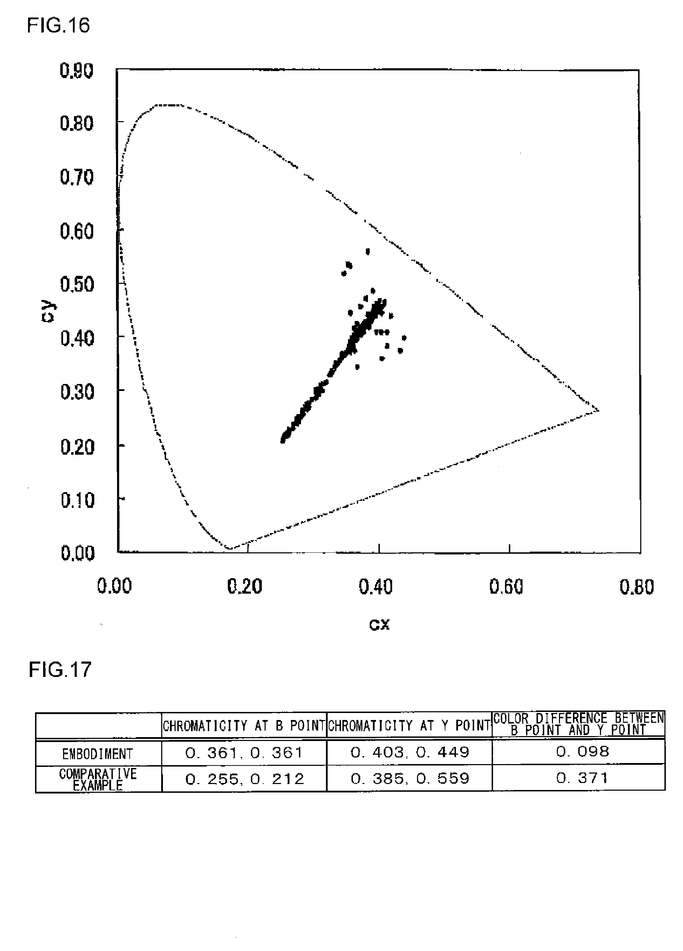

Fig. 13 is a graph illustrating the chromaticity distribution with respect to the axis in the light emitting module 30 according to the second embodiment, while Fig. 14 is a graph illustrating that in the light emitting module according to the comparative example. Fig. 15 is a graph illustrating the chromaticity distribution with respect to the b axis in the light emitting module 30 according to the second embodiment, while Fig. 16 is a graph illustrating that in the light emitting module according to the comparative example.

As known from Figs. 13 to 16, in the light emitting module 30 according to the second embodiment, the chromaticity is hardly changed with respect to both the a axis and b axis even when an area where the chromaticity is to be detected is moved. On the other hand, in the light emitting module according to the comparative example, the chromaticity is greatly changed with respect to both the axis and b axis, when an area where the chromaticity is to be detected is moved. Specifically, the chromaticity is changed from blue to yellow in the light emitting module according to the comparative example, and in particular, bluish white light is emitted near the area directly above the semiconductor light emitting element 40, and the bluish white light is changed to yellowish white light as it is away from the area directly above the semiconductor light emitting element 40.

Fig. 17 is a table showing the difference in the chromaticity at the B point and that at the Y point in each of the light emitting module 30 according to the second embodiment and that according to the comparative example. It is known that, while the color difference between the B point and the Y point is 0.37 in the light emitting module according to the comparative example, the color difference between them is 0.098 in the light emitting module 30 according to the second embodiment, thus being reduced to approximately 1/4.

As stated above, a light emitting module in which color shade is little can be obtained by performing mold forming so as to cover the semiconductor light emitting element 40, with the light wavelength conversion member 36 containing a first phosphor and a second phosphor, the wavelength range of the light emitted after the wavelength thereof has been converted by either of the two being approximately different from the excitation wavelength for the other.

The present invention should not be limited to the above embodiments, and variations in which each component of the embodiments is appropriately combined are also effective as embodiments of the invention. Various modifications, such as design modifications, can be made with respect to the above embodiments based on the knowledge of those skilled in the art. Such modified embodiments can also fall in the scope of the invention. Hereinafter, such examples will be described.

In a variation, a plurality of semiconductor light emitting elements are scattered on a flat surface, not on a straight line. The plurality of semiconductor light emitting elements are integrally covered with a light wavelength conversion member containing a plurality of phosphors, the wavelength range of the light emitted after the wavelength thereof has been converted by one of the plurality of phosphors being different from the excitation wavelengths for the others. Thereby, it becomes possible to obtain a light emitting module that emits light uniformly across a wide area on the flat surface.

In another variation, a light wavelength conversion member is formed into a shape in which, when semiconductor light emitting elements are covered with the light wavelength conversion member, the distance between the light emitting surface of each of the light emitting elements and the outer surface of the light wavelength conversion member is not uniform. In this case, the light wavelength conversion member may be formed into a cylindrical shape, polygonal column shape, conical shape, or polygonal pyramid shape. As stated above, by using a light wavelength conversion member containing a plurality of phosphors, the wavelength range of the light emitted after the wavelength thereof has been converted by one of the plurality of phosphors being different from the excitation wavelengths for the others, it becomes possible to obtain a light emitting module that emits light having uniform color, independently of the shape of a light wavelength conversion member. Accordingly, a light emitting module in which color shade is little can be provided even when a light wavelength conversion member is formed into various shapes, as stated above.

In still another variation, a light emitting module is provided by covering a semiconductor light emitting element with a light wavelength conversion member containing a first phosphor, a second phosphor, and a third phosphor, the wavelength range of the light emitted after the wavelength thereof has been converted by one of the three being different from the excitation wavelengths for the others. The first phosphor emits blue light by converting the light emitted by the semiconductor light emitting element. The second phosphor emits green light by converting the wavelength of the light emitted by the semiconductor light emitting element. The third phosphor emits red light by converting the wavelength of the light emitted by the semiconductor light emitting element. Also, in this embodiment, a light emitting module that emits uniform white light by additive color mixing of the blue light, green light, and red light can be provided.

In still another variation, a light emitting module is provided by integrally covering a plurality of semiconductor light emitting elements with a light wavelength conversion member containing a plurality of phosphors, the wavelength range of the light emitted after the wavelength thereof has been converted by one of the plurality of phosphors being different from the excitation wavelengths for the others. Although the plurality of semiconductor light emitting elements are not the same as each other, they are provided to emit the light in a common wavelength range. Each of the plurality of phosphors is provided to convert the wavelength of the light in the common wavelength range. Thereby, a light emitting module in which color shade is little can be provided even when a plurality of semiconductor light emitting elements, each of which emits ultraviolet light in a wavelength range slightly different from the others, are integrally covered.

### Industrial Applicability

The present invention can be used in a light emitting module, and be particularly used in a light emitting module comprising a light emitting element and a light wavelength conversion member configured to convert the wavelength of the light emitted by the light emitting element and to emit the light.

## Claims

1. A light emitting module comprising:
a light emitting element; and
a light wavelength conversion member configured to convert the wavelength of the light emitted by the light emitting element and to emit the light, wherein
the light wavelength conversion member contains a plurality of phosphors, the wavelength range of the light emitted after the wavelength thereof has been converted by one of the plurality of phosphors being different from the excitation wavelengths for the others, the light wavelength conversion member being formed to cover the light emitting element.

2. The light emitting module according to claim 1, wherein
a plurality of the light emitting elements are provided side by side to be spaced apart from each other, and wherein the light wavelength conversion member is formed so as to integrally cover the plurality of the light emitting elements.

3. The light emitting module according to claim 2, wherein
the plurality of the light emitting elements are arranged on the same flat surface.

4. The light emitting module according to claim 2 or claim 3, wherein
the plurality of the light emitting elements are provided side by side on a straight line.

5. The light emitting module according to claim 2 or claim 3, wherein
the plurality of the light emitting elements are arranged in a scattered manner on a flat surface.

6. A light emitting module comprising:
a light emitting element configured to emit near-ultraviolet light or the light in the wavelength range of short-wavelength visible light; and
a light wavelength conversion member that contains both a first phosphor represented by the general formula of M¹O₂•a(M²_{1-z},M⁴_{z})O•bM³X₂ (wherein, M¹ is at least one element selected from the group consisting of Si, Ge, Ti, Zr, and Sn; M² is at least one element selected from the group consisting of Mg, Ca, Sr, Ba, and Zn; M³ is at least one element selected from the group consisting of Mg, Ca, Sr, Ba, and Zn; X is at least one halogen element; M⁴ is at least one element in which Eu²⁺ is essential selected from the group consisting of rare earth elements and Mn; and a, b, and z are respectively within the ranges of 0.1 ≤ a ≤ 1.3, 0.1 ≤ b ≤ 0.25, and 0.03 < z < 0.8), and a second phosphor that converts the wavelength of the light emitted by the light emitting element and emits blue light, the light wavelength conversion member being formed so as to cover the light emitting element.

7. The light emitting module according to claim 1, wherein
a plurality of the light emitting elements are provided side by side to be spaced apart from each other, and wherein
the light wavelength conversion member is formed so as to integrally cover the plurality of the light emitting elements.

8. The light emitting module according to claim 5, wherein
the plurality of the light emitting elements are arranged on the same flat surface.

9. The light emitting module according to claim 7 or claim 8, wherein
the plurality of the light emitting elements are provided side by side on a straight line.

10. The light emitting module according to claim 7 or claim 8, wherein
the plurality of the light emitting elements are arranged in a scattered manner on a flat surface.
